# EUROPEAN PATENT APPLICATION

(11) **EP 4 756 072 A1**
(43) Date of publication of application: **10.06.2026**
(21) Application number: 25217535.1
(22) Date of filing: 21.11.2025
(51) Int. Cl.: C23C 16/44

(54) **SEMICONDUCTOR PROCESSING APPARATUS**

(30) Priority: 26.11.2024 US 202463725352 P
(71) Applicant: ASM IP Holding B.V., 1322 AP Almere (NL)
(72) Inventor: PROSERPIO, Davide, 1322 AP Almere (NL); OOSTERLAKEN, Theodorus G.M., 1322 AP Almere (NL); TERHORST, Herbert, 1322 AP Almere (NL); YUKANANTO, Riza, 1322 AP Almere (NL); BANKRAS, Radko Gerard, 1322 AP Almere (NL); JDIRA, Lucian, 1322 AP Almere (NL)
(74) Representative: V.O.

(57) **Abstract**

A semiconductor processing apparatus is disclosed. The apparatus comprises a process chamber configured to receive a plurality of substrates supported by a substrate boat; at least one gas injector for providing a gas to the process chamber; at least two gas exhaust outlets for removing a gas from the process chamber; and at least two gas exhaust conduits, each connected to a respective gas exhaust outlet. Each of the gas exhaust conduits extends in a vertical direction inside the process chamber over at least part of the substrate boat. At least one of the gas exhaust conduits comprises a plurality of holes spaced apart in the vertical direction.

## Description

### FIELD

The present disclosure relates generally to the field of semiconductor processing apparatus and methods, and to the field of device and integrated circuit manufacture. More particularly the present disclosure generally relates to apparatus and methods for providing gas to and removing gas from a process chamber of a semiconductor processing apparatus.

### BACKGROUND

In the field of semiconductor processing apparatus, batch processing tools have advantages over single wafer tools in that many wafers can be processed simultaneously, improving throughput. In processes which involve wafers having a high degree of surface enhancement, a large quantity of precursor gas is required in order to provide a uniform layer on the entire face of a wafer. The precursor flow should be as uniform as possible to avoid variations in amount of precursor deposited on different wafers in the same batch.

The use of multi-hole injectors for providing precursor gases to a process chamber of a batch processing tool, e.g. a vertical furnace, is known and can provide a more uniform distribution of gas along a height of the vertical furnace at the point of injection.

Any discussion, including discussion of problems and solutions, set forth in this section, has been included in this disclosure solely for the purpose of providing a context for the present disclosure, and should not be taken as an admission that any or all of the discussion was known at the time the invention was made or otherwise constitutes prior art.

### BRIEF SUMMARY

This summary introduces a selection of concepts in a simplified form, which are described in further detail below. This summary is not intended to necessarily identify key features or essential features of the claimed subject matter, nor is it intended to be used to limit the scope of the claimed subject matter.

According to a first aspect of the present invention, there is provided a semiconductor processing apparatus comprising a process chamber configured to receive a plurality of substrates supported by a substrate boat; at least one gas injector for providing a gas to the process chamber; at least two gas exhaust outlets for removing a gas from the process chamber; and at least two gas exhaust conduits, each connected to a respective gas exhaust outlet. Each of the gas exhaust conduits extends in a vertical direction inside the process chamber over at least part of the substrate boat. At least one of the gas exhaust conduits comprises a plurality of holes spaced apart in the vertical direction.

By providing at least two gas exhaust conduits, each connected to a respective gas exhaust outlet, individual control over gas exhaust paths is provided. By providing at least two gas exhaust conduits having different gas extraction profiles along the vertical direction, a total gas extraction profile for the process chamber can be controlled by controlling the amount of gas exhausted via each gas exhaust conduit. This allows the gas extraction profile to be matched to a gas injection profile to the process chamber, which allows for a more uniform gas flow in the process chamber. A more uniform gas flow results in less variability in the amount of precursor deposited on the plurality of substrates.

The plurality of holes may comprise at least ten holes. This can allow for greater control over the gas extraction profile of the gas exhaust conduit. The plurality of holes may comprise at least fifteen holes, or at least twenty holes.

The at least two gas exhaust conduits may comprise a top-extracting gas exhaust conduit having an inlet at a top end and an outlet at a bottom end, and a second gas exhaust conduit comprising a plurality of holes spaced apart in the vertical direction. The top-extracting gas exhaust conduit may not comprise a plurality of holes spaced apart in the vertical direction. The top-extracting gas exhaust conduit may thus provide a single gas exhaust path via the top of the top-extracting gas exhaust conduit.

The at least two gas exhaust conduits may comprise a first gas exhaust conduit having a first hole diameter of the plurality of holes comprised in the first gas exhaust conduit, and a second gas exhaust conduit having a second diameter of the plurality of holes comprised in the second gas exhaust conduit, wherein the first hole diameter is different to the second hole diameter.

The first hole diameter may increase towards an end of the first gas exhaust conduit which is opposite to an end of the first gas exhaust conduit at which the first gas exhaust conduit is connected to the respective gas exhaust outlet. This may provide a gas extraction profile which is top-heavy, or biased towards the top end of the first gas exhaust conduit.

The second hole diameter may decrease towards an end of the second gas exhaust conduit which is opposite to an end of the second gas exhaust conduit at which the second gas exhaust conduit is connected to the respective gas exhaust outlet. This may provide a gas extraction profile which is bottom-heavy, or biased towards the bottom end of the first gas exhaust conduit.

The at least two gas exhaust conduits may comprise a first gas exhaust conduit having a first hole spacing between adjacent holes in the plurality of holes and a second gas exhaust conduit having a second hole spacing between adjacent holes in the plurality of holes, wherein the first hole spacing is different to the second hole spacing. The first hole spacing may decrease towards an end of the first gas exhaust conduit which is opposite to an end of the first gas exhaust conduit at which the first gas exhaust conduit is connected to the respective gas exhaust outlet. The second hole spacing may increase towards an end of the second gas exhaust conduit which is opposite to an end of the second gas exhaust conduit at which the second gas exhaust conduit is connected to the respective gas exhaust outlet.

The plurality of holes in the first gas exhaust conduit may comprise a topmost hole which is arranged to be higher than a topmost substrate receiving position of the substrate boat.

The plurality of holes in the first gas exhaust conduit may comprise a topmost hole which is arranged to be lower than a topmost substrate receiving position of the substrate boat. The plurality of holes in the first gas exhaust conduit may comprise a topmost hole which is arranged to be substantially level with a topmost substrate receiving position of the substrate boat.

The plurality of holes in the second gas exhaust conduit may comprise a lowest hole which is arranged to be lower than a lowest substrate receiving position of the substrate boat. The plurality of holes in the second gas exhaust conduit may comprise a lowest hole which is arranged to be higher than a lowest substrate receiving position of the substrate boat. The plurality of holes in the second gas exhaust conduit may comprise a lowest hole which is arranged to be substantially level with a lowest substrate receiving position of the substrate boat.

The first gas exhaust conduit or top-extracting gas exhaust conduit may be configured to preferentially extract gas from an upper region of the process chamber and the second gas exhaust conduit may be configured to preferentially extract gas from a lower region of the process chamber.

The at least one gas injector may be located diametrically opposite to a midpoint of the at least two gas exhaust conduits in a direction along a circumference of the process chamber.

Each of the at least two gas exhaust conduits may have an internal gas conduction channel extending from a bottom end of the respective gas exhaust conduit to a top end opposite the bottom end, wherein the internal gas conduction channel has a cross-sectional area in a horizontal plane of at least 1000mm². The cross-sectional area in a horizontal plane may be at least 2000mm². The internal gas conduction channel may have a rounded rectangular shape in the horizonal plane.

Each of the at least two gas exhaust conduits may be positioned in the process chamber such that a longer side of the rectangular shape is substantially tangential to a circumference of the process chamber.

The second gas exhaust conduit may have a top end which is lower than a top end of the first gas exhaust conduit.

The semiconductor processing apparatus may comprise a base pressure evacuation outlet for removing gas from the process chamber, wherein the base pressure evacuation outlet is not connected to any of the at least two gas exhaust conduits.

The semiconductor processing apparatus may comprise a vacuum pump in fluid communication with the gas exhaust outlets.

The semiconductor processing apparatus may comprise a first gas line providing a fluid connection between the first gas exhaust outlet and the vacuum pump, and a second gas line providing a fluid connection between the second gas exhaust outlet and the vacuum pump, wherein the first gas line comprises a first gas control valve and the second gas line comprises a second gas control valve.

The semiconductor processing apparatus may comprise a controller configured to control the first gas flow control valve and the second gas flow control valve such that the first gas flow control valve is open for a first duration and the second gas flow control valve is open for a second, non-overlapping duration. The first duration and the second duration may be chosen so as to match a gas exhaust profile provided by the at least two gas exhaust outlets with a gas injection profile provided by the at least one injector.

The first and second gas control valves may be pressure control valves configured to control a flow rate of a gas through the respective gas line, wherein the first gas line comprises at least one first gas line pressure sensor and the second gas line comprises at least one second gas line pressure sensor.

At least one of the pressure sensors may be a differential pressure sensor configured to measure a pressure difference between the respective gas line and the process chamber. The first gas line pressure sensor may be a differential pressure sensor configured to measure a pressure difference between the first gas line and the process chamber. The second gas line pressure sensor may be a differential pressure sensor configured to measure a pressure difference between the second gas line and the process chamber. By using a differential pressure sensor in both gas lines, the relative gas flow rate through the gas lines can be determined based on the differential pressure measurements, without requiring calibration for e.g gas composition, temperature, and pressure.

The semiconductor processing apparatus may comprise a controller configured to control the pressure control valves so as to provide a desired flow rate ratio of gas through the first and the second gas lines.

The controller may be configured to control the flow rate ratio so as to match a total gas exhaust profile provided by the at least two gas exhaust outlets with a gas injection profile provided by the at least one injector.

According to a second aspect of the present invention there is provided a method of controlling gas flow through a semiconductor processing apparatus, the semiconductor processing apparatus comprising a process chamber configured to receive a plurality of substrates supported by a substrate boat; at least one gas injector for providing a gas to the process chamber; at least two gas exhaust outlets for removing a gas from the process chamber; at least two gas exhaust conduits, each connected to a respective gas exhaust outlet; a vacuum pump in fluid communication with the gas exhaust outlets; and means for controlling a flow of gas through each of the at least two gas exhaust conduits, the method comprising the steps of: providing a gas to the process chamber using the at least one gas injector; and controlling a flow of gas through each of the at least two gas exhaust conduits so as to match a total gas exhaust profile provided by the at least two gas exhaust outlets with a gas injection profile provided by the at least one injector.

The means for controlling gas flow may comprise a first valve for controlling gas flow from the first gas exhaust conduit to the vacuum pump and a second valve for controlling gas from the second gas exhaust conduit to the vacuum pump.

The method may comprise controlling the first and second valves so as to provide a different gas flow rate from the first gas exhaust conduit as compared with a simultaneous gas flow rate from the second gas exhaust conduit.

The method may comprise controlling the first and second valves so as to alternate in time the gas flow from the first gas exhaust conduit with the gas from the second gas exhaust conduit.

Other technical features may be readily apparent to one skilled in the art from the following figures, descriptions, and claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE DRAWINGS

Certain embodiments of the present invention will now be described, by way of example, with reference to the accompanying drawings, in which:
FIG. 1 is a schematic cross-sectional view of a semiconductor processing apparatus according to embodiments of the present invention;
FIG. 2 is a schematic cross-sectional view of a flange assembly which may be comprised in a semiconductor processing apparatus according to embodiments of the present invention;
FIG. 3 is a schematic perspective view of a multi-hole injector and a dump injector which may be comprised in a semiconductor processing apparatus according to embodiments of the present invention;
FIG. 4 to FIG. 7 illustrate various embodiments of a gas divider ring, in plan view, which may be comprised in a semiconductor processing apparatus according to embodiments of the present invention;
FIG. 8 is a schematic perspective view of a pair of gas exhaust conduits which may be comprised in a semiconductor processing apparatus according to embodiments of the present invention, having hole diameters which vary;
FIG. 9 is a schematic perspective view of a pair of gas exhaust conduits which may be comprised in a semiconductor processing apparatus according to embodiments of the present invention, having hole spacings which vary;
FIG. 10 is a schematic perspective view of a pair of gas exhaust conduits which may be comprised in a semiconductor processing apparatus according to embodiments of the present invention, one of the gas exhaust conduits comprising a plurality of holes and being closed at a top end, the other gas exhaust conduit not comprising the plurality of holes and being open at a top end.
FIG. 11 is a schematic cross-sectional view of a gas exhaust conduit which may be comprised in a semiconductor processing apparatus according to embodiments of the present invention, the cross-section being taken at a point between two holes of the gas exhaust conduit;
FIG. 12 is a schematic view of part of a semiconductor processing apparatus according to embodiments of the present invention;
FIG. 13 is a flow chart of a method of controlling a gas flow according to embodiments of the present invention.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

The description of exemplary embodiments of methods and compositions provided below is merely exemplary and is intended for purposes of illustration only. The following description is not intended to limit the scope of the disclosure or the claims. Moreover, recitation of multiple embodiments having indicated features or steps is not intended to exclude other embodiments having additional features or steps or other embodiments incorporating different combinations of the stated features or steps.

Where in the present disclosure two or more elements are referred to as being "in fluid communication", it is meant that a fluid such as a gas or liquid or mixture thereof can flow between the elements, in one or both directions. The fluid communication may be achieved, for example, by means of a gas line, tube, pipe, inlet, outlet, or any combination thereof. The fluid communication may be interruptible; for example, a valve or other flow control element may be present.

In this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, etc. in some embodiments. Further, in this disclosure, the terms "including," "constituted by" and "having" can refer independently to "typically or broadly comprising," "comprising," "consisting essentially of," or "consisting of" in some embodiments. In this disclosure, any defined meanings do not necessarily exclude ordinary and customary meanings in some embodiments. In some cases, percentages indicate herein can be relative or absolute percentages.

A number of example materials are given throughout the embodiments of the current disclosure, it should be noted that the chemical formulas given for each of the example materials should not be construed as limiting and that the non-limiting example materials given should not be limited by a given example stoichiometry.

In the specification, it will be understood that the term "on" or "over" may be used to describe a relative location relationship. Another element, film or layer may be directly on a mentioned layer, or another layer (an intermediate layer) or element may be intervened therebetween, or a layer may be disposed on a mentioned layer but not completely cover a surface of the mentioned layer. Therefore, unless the term "directly" is separately used, the term "on" or "over" will be construed to be a relative concept. Similarly to this, it will be understood the term "under", "underlying", or "below" will be construed to be relative concepts.

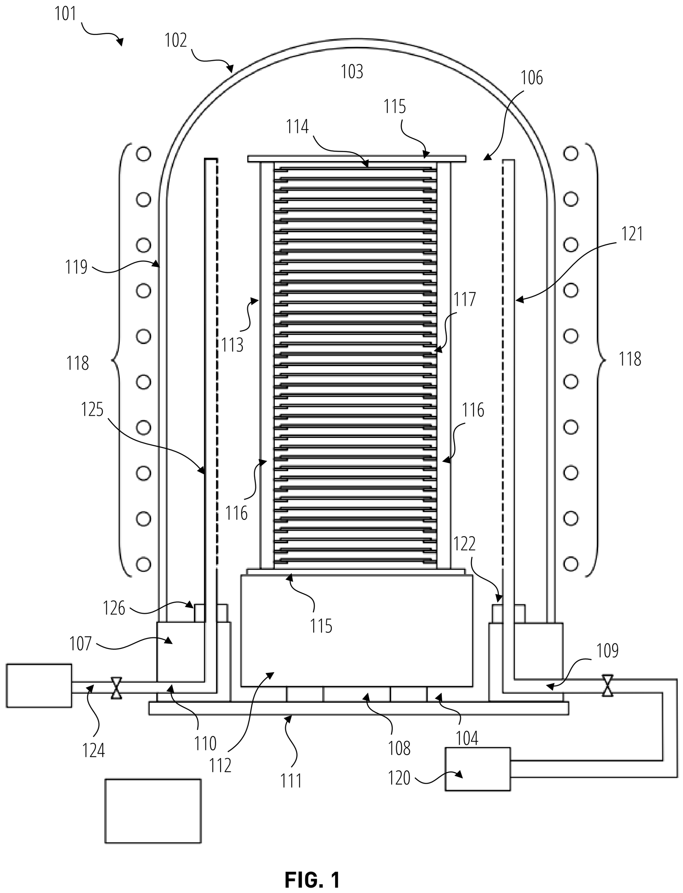

Referring to FIG. 1, a semiconductor processing apparatus 101 according to embodiments of the present invention is shown. The semiconductor processing apparatus 101 comprises a process chamber 102 which is generally bell jar shaped, having a closed top end 103, a closable bottom end 104, and an interior space. The semiconductor processing apparatus 101 may be a vertical furnace and the process chamber 102 may accordingly extend in a vertical direction between the top end 103 and the bottom end 104. The semiconductor processing apparatus 101 may comprise a flange assembly 107 for at least partially supporting the process chamber 102 at the bottom end 104. The flange assembly 107 may be generally circular in shape as viewed along the vertical direction. The flange assembly 107 may comprise a central opening 108 and various gas inlets 109 and gas outlets 110 for providing or removing a gas from the interior space 106 respectively. The flange assembly 107 may be configured to partially close off the bottom end 104 of the process chamber 102.

The semiconductor processing apparatus 101 comprises a doorplate 111 configured to at least partially close off the bottom end 104 of the process chamber 102. The doorplate 111 may support a pedestal 112 thereon. The pedestal 112 may be configured to support a substrate carrier 113, also referred to as a boat. In some embodiments, no pedestal may be provided and the substrate carrier 113 may be supported directly on the doorplate 111. The pedestal 112 (if included) and boat may be inserted into and removed from the process chamber 102 through the bottom end 104 by moving the doorplate 111 in a vertical direction.

The substrate carrier 113 is configured to support a plurality of substrates 114 therein. The plurality of substrates 114 may be spaced apart in a vertical direction with a separation d. The substrate carrier 113 may comprise two end plates 115 spaced apart by a plurality of support rods 116. The plurality of support rods 116 may comprise a plurality of sets of slots 117 or projections for supporting the plurality of substrates, each set of slots 117 or projections being spaced apart from the other sets of slots 117 or projections in the vertical direction. Each set of slots 117 or projections being at a same vertical position forms a respective substrate receiving position.

The semiconductor processing apparatus 101 may comprise a heater for heating the process chamber 102 and thereby heating the interior space, for example in the form of heating coils disposed around an outer surface of the process chamber 102.

The semiconductor processing apparatus 101 comprises at least one gas inlet 109 in the flange assembly 107 for providing a gas or gases to the interior space 106 of the process chamber 102. The at least one gas inlet 109 may each be connected to one or more respective gas sources. The gas sources may include process gas sources and purge gas sources. The gas inlets 109 may be categorised according to the type of gas to be provided therethrough; for example, the flange assembly 107 may comprise one or more process gas inlets and one or more purge gas inlets.

The semiconductor processing apparatus 101 comprises at least one injector 121, each in fluid communication with a respective gas inlet 109. The semiconductor processing apparatus 101 may comprise the same number of injectors 121 as gas inlets 109, or may comprise fewer injectors 121 than gas inlets 109, that is, one or more gas inlets 109 may not be connected to an injector 121. The injector 121 or each of the injectors 121 extends in a vertical direction within the process chamber 102. The injector 121 or each of the injectors 121 may be supported at a bottom end by an injector holder 122 which may be removably attached to the flange assembly 107. In some embodiments, the semiconductor processing apparatus 101 comprises at least one multi-hole injector and at least one dump injector, described in more detail hereinafter.

The semiconductor processing apparatus 101 comprises a plurality of gas outlets 110 in the flange assembly 107 for removing a gas or gases from the interior space 106 of the process chamber 102. The plurality of gas outlets 110 may each be in fluid communication with to a vacuum pump 123 via respective exhaust gas lines 124. The semiconductor processing apparatus 101 comprises a plurality of gas exhaust conduits 125, each in fluid communication with a respective gas outlet 110. Each of the gas exhaust conduits 125 may be supported at a bottom end by a gas exhaust conduit holder 126 which may be removably attached to the flange assembly 107. Each of the gas exhaust conduits 125 extends in a vertical direction inside the process chamber 102 and comprises a plurality of holes spaced apart in the vertical direction. The semiconductor processing apparatus 101 may comprise the same number of gas exhaust conduits 125 as gas outlets 110, or may comprise fewer gas exhaust conduits 125 than gas outlets 110, that is, one or more gas outlets 110 may not be connected to a gas exhaust conduit 125.

The semiconductor processing apparatus 101 may comprise a controller 105 which may be configured to control various elements of the semiconductor processing apparatus 101. The controller 105 may comprise a memory for storing, for example, program instructions, setpoint values, characterisation data, and other data. The controller 105 may comprise a processor for executing program instructions which may be loaded from the memory. The controller 105 may be configured to receive data from sensors in the semiconductor processing apparatus 101, for example pressure sensors, temperature sensors, and/or other types of sensors. The controller 105 may be configured to control elements of the semiconductor processing apparatus 101 by sending control signals to, for example, gas flow control valves, heating elements, water cooling elements.

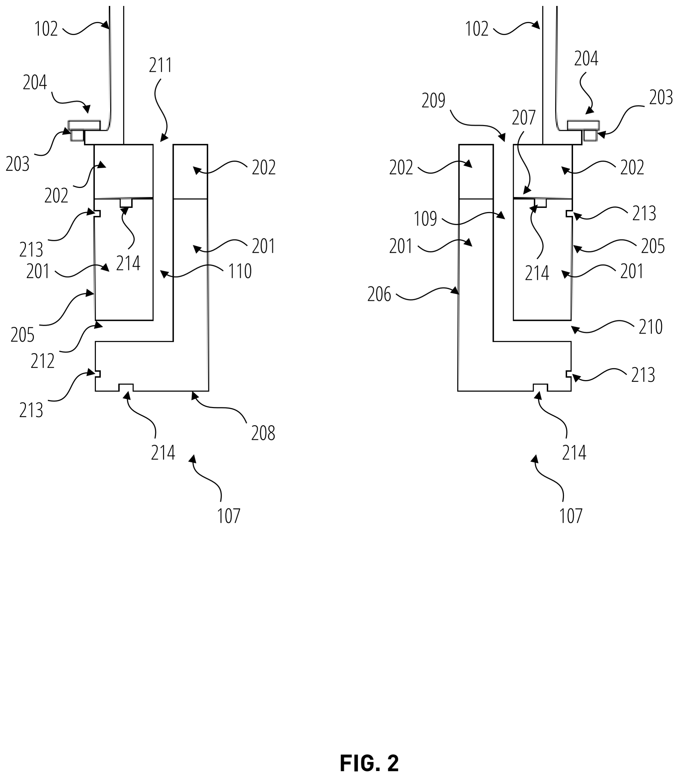

Referring to FIG. 2, the flange assembly 107 may comprise a gas divider ring 201, optionally a liner suspension ring 202 supported on the gas divider ring 201, a process tube suspension ring 203, and a clamp ring 204.

The gas divider ring 201 may be generally tube shaped with an outer curved surface 205 facing away from a central axis of the gas divider ring 201, an inner curved surface 206 facing towards the central axis of the gas divider ring 201, a top face 207, and a bottom face 208 opposite the top face 207. When installed in a semiconductor processing apparatus 101, the top face 207 faces towards the top end 103 of the process chamber 102.

The gas divider ring 201 comprises at least one gas inlet 109 extending between a top inlet position 209 at the top face 207 of the gas divider ring 201 and a bottom inlet position 210 at the outer surface 119 of the gas divider ring 201. The gas inlet 109 may extend generally downwards from the top inlet position 209 and subsequently outwards towards the outer curved surface 205 of the gas divider ring 201 to the bottom inlet position 210. A gas to be provided to the process chamber 102 may flow from a gas source 120 (FIG. 1) to the bottom inlet position 210, then through the gas divider ring 201 to the top inlet position 209, and subsequently flows into an injector 121 (FIG. 1) through a conduit in the liner suspension ring 202 (if provided) or directly (if liner suspension ring 202 not provided).

The gas divider ring 201 comprises at least two gas outlets 110, each extending between a respective top outlet position 211 at the top face 207 of the gas divider ring 201 and a respective bottom outlet position 212 at the outer surface 119 of the gas divider ring 201. The gas outlets 110 may extend generally downwards from the respective top outlet position 211 and subsequently outwards towards the outer curved surface 205 of the gas divider ring 201 to the respective bottom outlet position 212. A gas to be removed from the process chamber 102 may flow through a gas exhaust conduit 125 (FIG. 1) to the top outlet position 211, either directly or via a conduit in the liner suspension ring 202 (if provided), then subsequently may flow from the top outlet position 211 to the bottom outlet position 212 through the gas divider ring 201 and thence to an exhaust gas line 124 (FIG. 1).

The gas divider ring 201 may comprise grooves 213 in the outer curved surface 205 for receiving heating wires and channels 214 in the top face 207 and bottom face 208 for receiving water cooling tubes. The heating wires and water cooling tubes may be used to control a temperature of the gas divider ring 201. The gas divider ring 201 may comprise cut-outs in the outer curved surface 205 between the grooves 213 at the top and the bottom of the gas divider ring 201. Removing material by providing cut-outs allows for less material to be used in manufacture. The gas divider ring 201 is also lighter and the thermal response is improved.

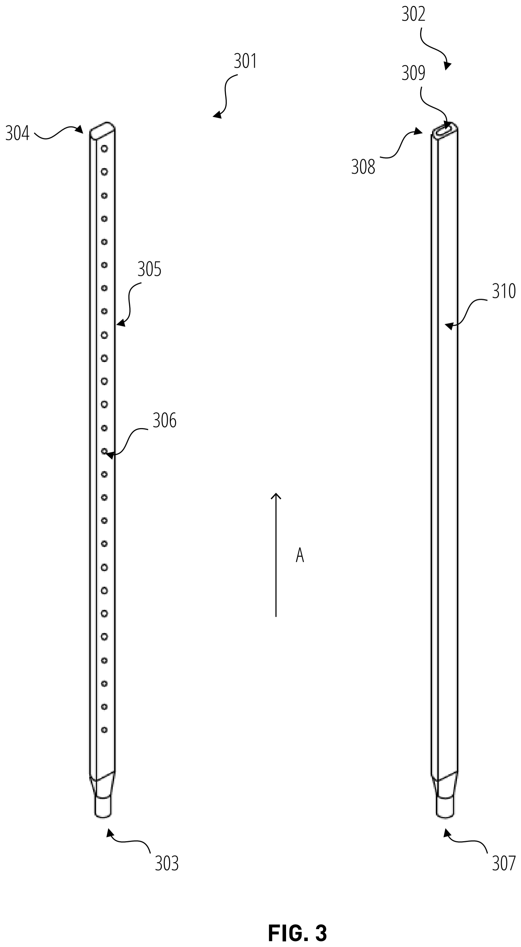

Referring to FIG. 3, a multi-hole injector 301 and a dump injector 302 are illustrated. The multi-hole injector 301 extends from a bottom, open end 303 at which the multi-hole injector 301 is connectable to a gas inlet, to a top, closed end 304, along a main axis A. The multi-hole injector 301 has an internal gas conduction channel (not visible in FIG. 3) into which gas flows from the bottom end 303, the gas conduction channel being defined by a multi-hole injector wall 305. The multi-hole injector 301 comprises a plurality of holes 306 in the multi-hole injector wall 305. The plurality of holes 306 are spaced apart along the main axis of the multi-hole injector 301. The plurality of holes 306 may each have the same diameter, or may have different diameters, for example, the diameter of the holes may increase or decrease towards the top end 304 of the multi-hole injector 301. The spacing of the holes 306 may be constant or may increase or decrease towards the top end 304 of the multi-hole injector 301. In embodiments wherein more than one multi-hole injector 301 is provided, the hole diameters and/or spacings and variations thereof may be the same or different between the plurality of multi-hole injectors 301. The holes 306 may be arranged such that, when a multi-hole injector 301 is provided in a process chamber 102 of a semiconductor processing apparatus 101 according to embodiments of the present invention, gas is provided to the process chamber 102 in a radial direction towards a central axis of the process chamber 102. The holes 306 may be arranged such that gas is provided to the process chamber 102 in a circumferential direction of the process chamber 102.

The dump injector 302 extends from a bottom, open end 307 at which the dump injector 302 is connectable to a gas inlet, to a top open end 308, along a main axis A. The dump injector 302 has an internal gas conduction channel 309 into which gas flows from the bottom end 307, the gas conduction channel 309 being defined by a dump injector wall 310. The dump injector 302 does not comprise holes in the dump injector wall 310, thus allowing gas to flow from the bottom end 307 through the gas conduction channel and out of the top end 308.

The multi-hole injector 301 and the dump injector 302 may have a channel cross-section in a horizontal plane and the channel cross-section may be generally circular shaped, or may be rectangular or square in shape with rounded corners, or may have another, different shape.

The multi-hole injector 301 has a gas injection pattern along the height of the process chamber which may not be uniform. For example, the flow rate of gas entering the process chamber through the holes 306 of the multi-hole injector may decrease towards the top end of the process chamber.

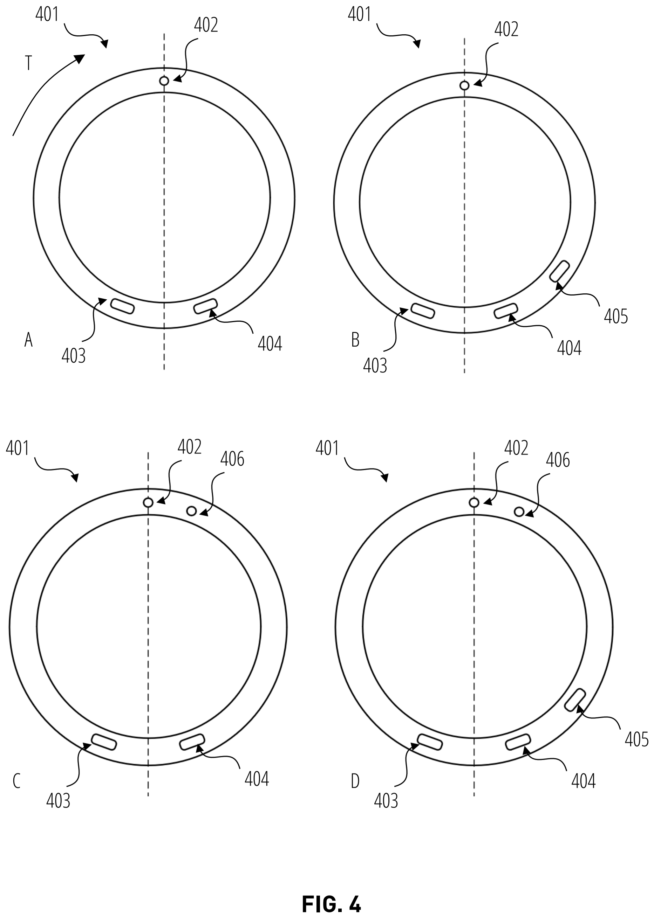

Referring to FIG. 4 to FIG. 7, various gas inlet and gas outlet configurations are shown for a gas divider ring 401 which may be included in a semiconductor processing apparatus 101 according to embodiments of the present invention. For ease of illustration, the channels 214 are not illustrated in FIG. 4 to FIG. 7 but it will be understood by the skilled person than channels 214 may be included in any of the illustrated configurations.

Referring to FIG. 4, in some embodiments, the gas divider ring 401 has a first gas inlet 402 for connecting to a multi-hole injector, and a first gas outlet 403 and second gas outlet 404 for connecting to respective gas exhaust conduits (configuration A in FIG. 4). The gas outlets 403, 404 for connecting to respective gas exhaust conduits are distributed in the circumferential direction T. The first gas outlet 403 and the second gas outlet 404 have a midpoint in the circumferential direction which is diametrically opposite to the first gas inlet 402.

The first gas inlet 402 may be in fluid communication with a single gas source or may be in fluid communication with multiple gas sources such that different gases may be provided to the gas inlet at different times. For example, the first gas inlet 402 may be in fluid communication with one or more of a plurality of process gas sources. The first gas inlet 402 may be additionally in fluid communication with one or more of a plurality of purge gas sources.

In some embodiments, the gas divider ring 401 has three gas outlets comprising the first gas outlet 403, the second gas outlet 404, and a third gas outlet 405 which does not connect to a gas exhaust conduit (configuration B in FIG. 4). The third gas outlet may be a base pressure evacuation outlet which may allow for faster removal of gas from the process chamber 102 when opened. The midpoint of the first gas outlet 403 and the second gas outlet 404 in the circumferential direction remains diametrically opposite to the first gas inlet 402. In some embodiments, the gas divider ring 401 may include a dump gas inlet 406 for connecting to a dump injector (configuration C in FIG. 4). The dump gas inlet 406 may be in fluid communication with one or more purge gas sources. The dump gas inlet 406 may not be connected to a process gas source. In some embodiments, the gas divider ring 401 may include the dump gas inlet 406 and the third gas outlet 405 (configuration D in FIG. 4)

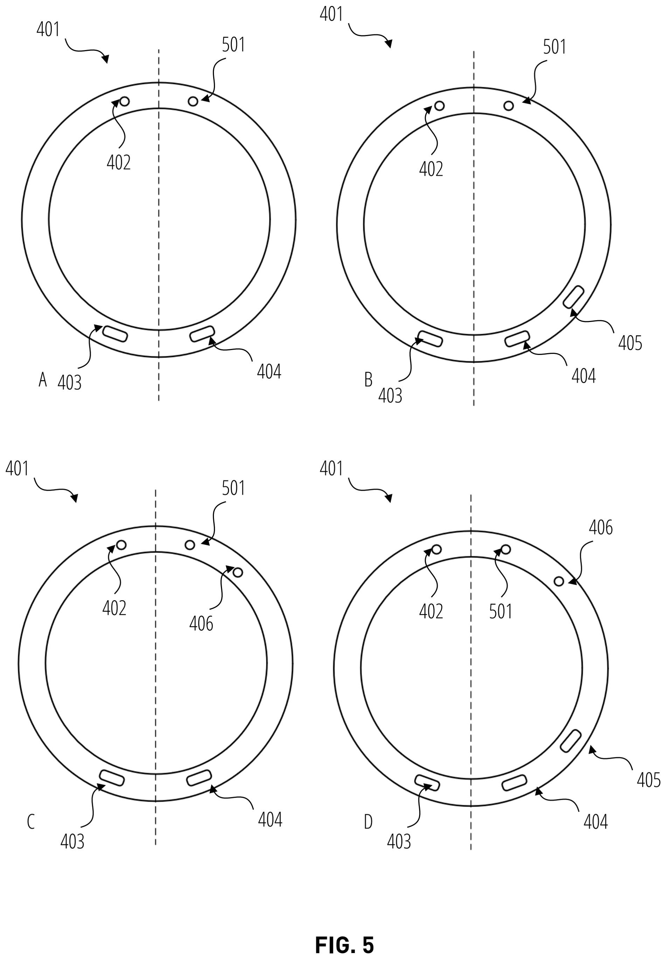

Referring to FIG. 5, in some embodiments, the gas divider ring has a first gas inlet 402 and a second gas inlet 501 for connecting to respective multi-hole injectors, and a first gas outlet 403 and second gas outlet 404 for connecting to respective gas exhaust conduits (configuration A in FIG. 5). The first gas inlet 402 and the second gas inlet 501 for connecting to respective multi-hole injectors are distributed in the circumferential direction T. The first gas outlet 403 and the second gas outlet 404 are distributed in the circumferential direction T. The first gas outlet 403 and the second gas outlet 404 have a midpoint in the circumferential direction which is diametrically opposite to a midpoint in the circumferential direction of the first gas inlet 402 and the second gas inlet 501.

The first gas inlet 402 and the second gas inlet 501 may each be in fluid communication with a respective single gas source or may be in fluid communication with multiple gas sources such that different gases may be provided to a gas inlet 402, 501 at different times. For example, the first gas inlet 402 may be in fluid communication with one or more of a plurality of process gas sources. The first gas inlet 402 may be additionally in fluid communication with one or more of a plurality of purge gas sources. The second gas inlet 501 may be in fluid communication with one or more of a plurality of process gas sources. The second gas inlet 501 may be additionally in fluid communication with one or more of a plurality of purge gas sources. The first gas inlet 402 may be in fluid communication with a first process gas source and the second gas inlet 501 may be in fluid communication with a second process gas source different to the first process gas source. The first process gas source may be configured to provide a different process gas to the second process gas source.

In some embodiments, the gas divider ring 401 has three gas outlets comprising the first gas outlet 403, the second gas outlet 404, and a third gas outlet 405 being an overflow gas outlet which does not connect to a gas exhaust conduit (configuration B in FIG. 4). The midpoint of the first gas outlet 403 and the second gas outlet 404 in the circumferential direction remains diametrically opposite to the midpoint in the circumferential direction of the first gas inlet 402 and the second gas inlet 501. In some embodiments, the gas divider ring 401 may include a dump gas inlet 406 for connecting to a dump injector (configuration C in FIG. 5). The dump gas inlet 406 may be in fluid communication with one or more purge gas sources. The dump gas inlet 406 may not be connected to a process gas source. In some embodiments, the gas divider ring 401 may include the dump gas inlet 406 and the third gas outlet 405 (configuration D in FIG. 5)

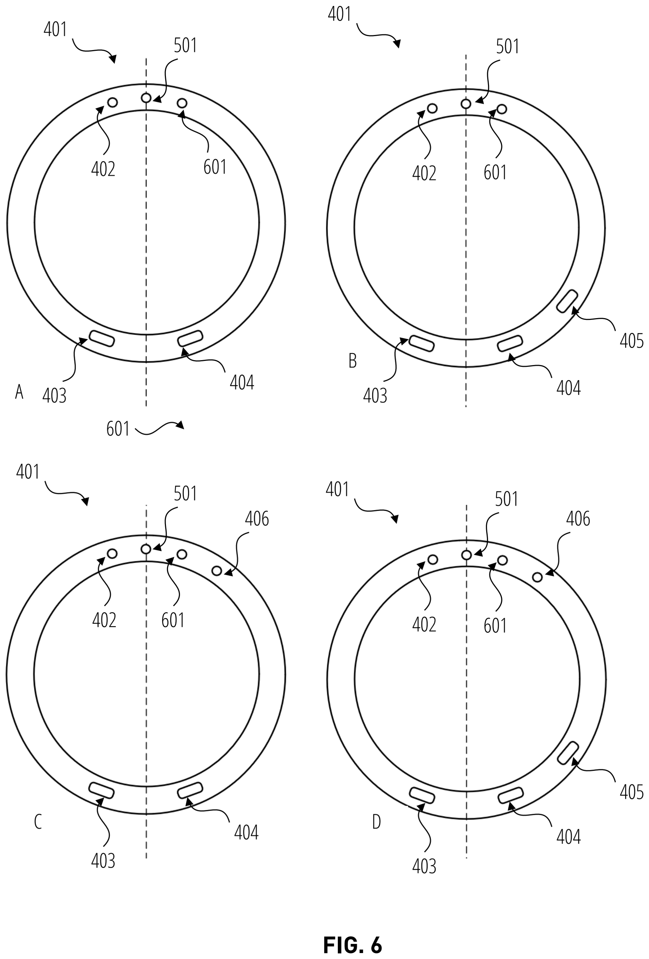

Referring to FIG. 6, in some embodiments, the gas divider ring 401 has a first gas inlet 402 a second gas inlet 501, and a third gas inlet 601 for connecting to respective multi-hole injectors, and a first gas outlet 403 and second gas outlet 404 for connecting to respective gas exhaust conduits (configuration A in FIG. 6). The first gas inlet 402, the second gas inlet 501, and the third gas inlet 601 for connecting to respective multi-hole injectors are distributed in the circumferential direction T. The first gas outlet 403 and the second gas outlet 404 are distributed in the circumferential direction T. The first gas outlet 403 and the second gas outlet 404 have a midpoint in the circumferential direction which is diametrically opposite to a midpoint in the circumferential direction of the first gas inlet 402, the second gas inlet 501, and the third gas inlet 601.

The first gas inlet 402, the second gas inlet 501, and the third gas inlet 601 may each be in fluid communication with a respective single gas source or may be in fluid communication with multiple gas sources such that different gases may be provided to a gas inlet 402, 501, 601 at different times. For example, the first gas inlet 402 may be in fluid communication with one or more of a plurality of process gas sources. The first gas inlet 402 may be additionally in fluid communication with one or more of a plurality of purge gas sources. The second gas inlet 501 may be in fluid communication with one or more of a plurality of process gas sources. The second gas inlet 501 may be additionally in fluid communication with one or more of a plurality of purge gas sources. The third gas inlet 601 may be in fluid communication with one or more of a plurality of process gas sources. The third gas inlet 601 may be additionally in fluid communication with one or more of a plurality of purge gas sources. The first gas inlet 402 may be in fluid communication with a first process gas source and the second gas inlet 501 may be in fluid communication with a second process gas source different to the first process gas source and the third gas inlet 601 may be in fluid communication with a third process gas source different to the first process gas source and the second process gas source. The process gases provided by each of the first process gas source, the second process gas source, and the third process gas source may each be different to one another.

In some embodiments, the gas divider ring 401 has three gas outlets comprising the first gas outlet 403, the second gas outlet 404, and a third gas outlet 405 being an overflow gas outlet which does not connect to a gas exhaust conduit (configuration B in FIG. 6). The midpoint of the first gas outlet 403 and the second gas outlet 404 in the circumferential direction remains diametrically opposite to the midpoint in the circumferential direction of the first gas inlet 402, the second gas inlet 501, and the third gas inlet 601. In some embodiments, the gas divider ring 401 may include a dump gas inlet 406 for connecting to a dump injector (configuration C in FIG. 6). The dump gas inlet 406 may be in fluid communication with one or more purge gas sources. The dump gas inlet 406 may not be connected to a process gas source. In some embodiments, the gas divider ring 401 may include the dump gas inlet 406 and the third gas outlet 405 (configuration D in FIG. 6)

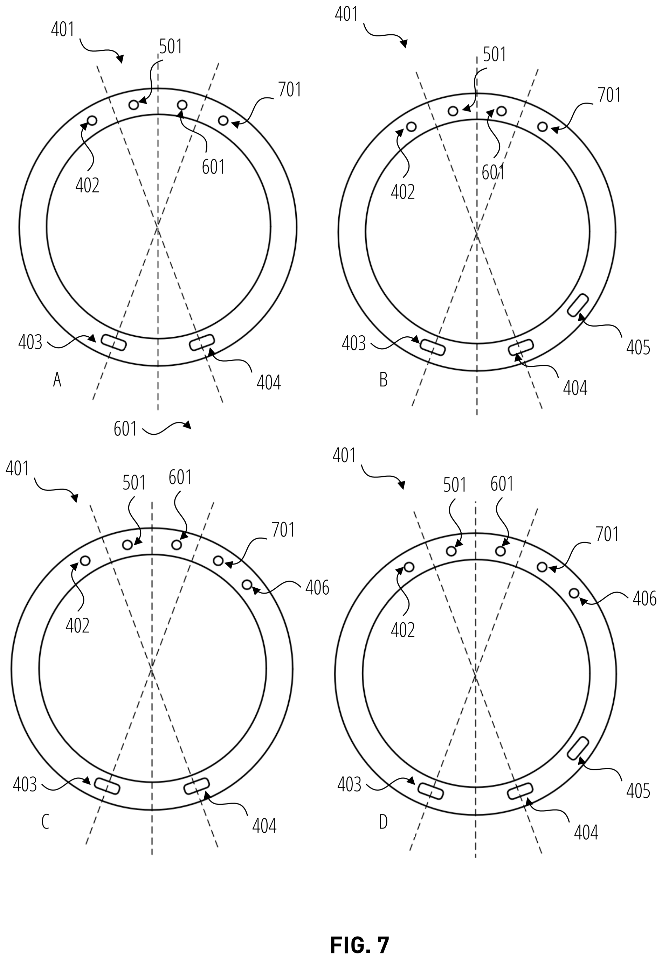

Referring to FIG. 7, in some embodiments, the gas divider ring 401 has a first gas inlet 402, a second gas inlet 501, a third gas inlet 601, and a fourth gas inlet 701 for connecting to respective multi-hole injectors, and a first gas outlet 403 and second gas outlet 404 for connecting to respective gas exhaust conduits (configuration A in FIG. 6). The first gas inlet 402, the second gas inlet 501, the third gas inlet 601, and the fourth gas inlet 701 for connecting to respective multi-hole injectors are distributed in the circumferential direction T. The first gas outlet 403 and the second gas outlet 404 are distributed in the circumferential direction T. The first gas outlet 403 and the second gas outlet 404 have a midpoint in the circumferential direction which is diametrically opposite to a midpoint in the circumferential direction of the first gas inlet 402, the second gas inlet 501, the third gas inlet 601, and the fourth gas inlet 701.

The first gas inlet 402, the second gas inlet 501, the third gas inlet 601, and the fourth gas inlet 701 may each be in fluid communication with a respective single gas source or may be in fluid communication with multiple gas sources such that different gases may be provided to a gas inlet 402, 501, 601, 701 at different times. For example, the first gas inlet 402 may be in fluid communication with one or more of a plurality of process gas sources. The first gas inlet 402 may be additionally in fluid communication with one or more of a plurality of purge gas sources. The second gas inlet 501 may be in fluid communication with one or more of a plurality of process gas sources. The second gas inlet 501 may be additionally in fluid communication with one or more of a plurality of purge gas sources. The third gas inlet 601 may be in fluid communication with one or more of a plurality of process gas sources. The third gas inlet 601 may be additionally in fluid communication with one or more of a plurality of purge gas sources. The fourth gas inlet 701 may be in fluid communication with one or more of a plurality of process gas sources. The fourth gas inlet 701 may be additionally in fluid communication with one or more of a plurality of purge gas sources. The first gas inlet 402 may be in fluid communication with a first process gas source and the second gas inlet 501 may be in fluid communication with a second process gas source different to the first process gas source and the third gas inlet 601 may be in fluid communication with a third process gas source different to the first process gas source and the second process gas source and the fourth gas inlet 701 may be in fluid communication with a fourth process gas source different to the first, second, and third process gas sources. The process gases provided by each of the first process gas source, the second process gas source, the third process gas source, and the fourth process gas source may each be different to one another.

In some embodiments, the gas divider ring 401 has three gas outlets comprising the first gas outlet 403, the second gas outlet 404, and a third gas outlet 405 being an overflow gas outlet which does not connect to a gas exhaust conduit (configuration B in FIG. 7). The midpoint of the first gas outlet 403 and the second gas outlet 404 in the circumferential direction remains diametrically opposite to the midpoint in the circumferential direction of the first gas inlet 402, the second gas inlet 501, the third gas inlet 601, and the fourth gas inlet 701. In some embodiments, the gas divider ring 401 may include a dump gas inlet 406 for connecting to a dump injector (configuration C in FIG. 7). The dump gas inlet 406 may be in fluid communication with one or more purge gas sources. The dump gas inlet 406 may not be connected to a process gas source. In some embodiments, the gas divider ring 401 may include the dump gas inlet 406 and the third gas outlet 405 (configuration D in FIG. 7)

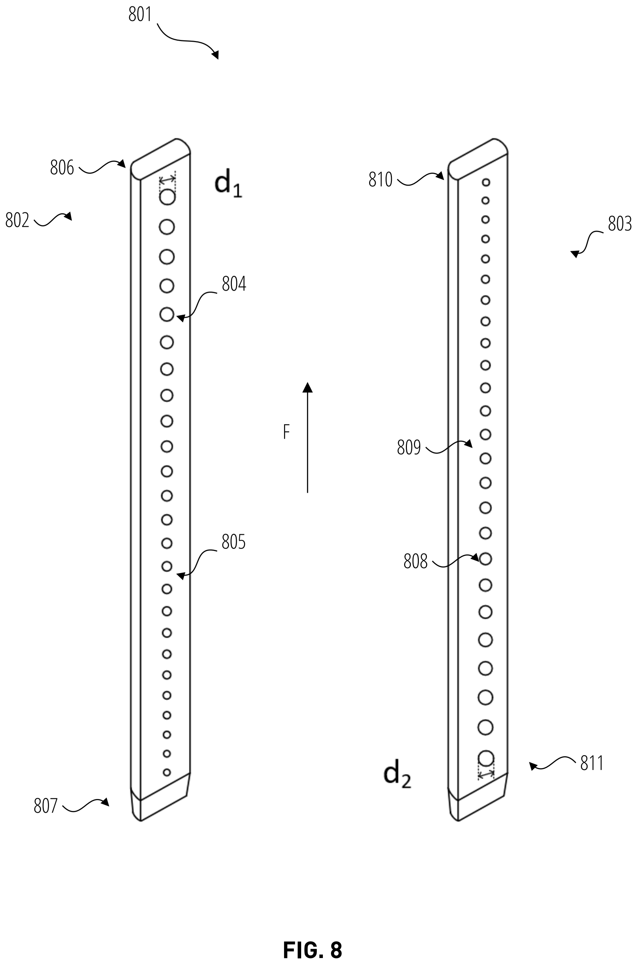

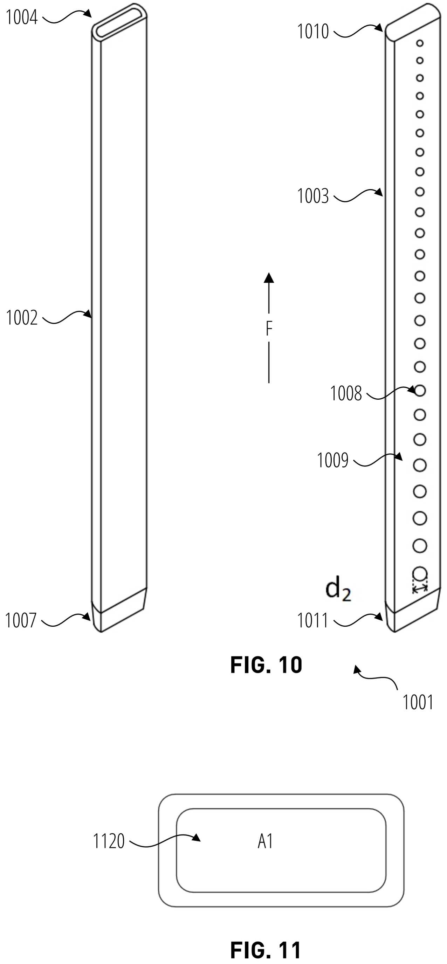

Referring to FIG. 8, a gas exhaust conduit pair 801 of a first gas exhaust conduit 802 and a second gas exhaust conduit 803 which may be included in a semiconductor processing apparatus 101 according to embodiments of the present invention is shown. Each gas exhaust conduit 801, 802 extends from a respective bottom, open end at which the gas exhaust conduit 801, 802 is connectable to a gas outlet 110 to a top, closed end, along a main axis F. Each gas exhaust conduit 801, 802 has a respective gas exhaust conduit internal channel (FIG. 11) defined by a gas exhaust conduit wall.

The first gas exhaust conduit 802 comprises a first set of holes 804 in the first gas exhaust conduit wall 805, such that a gas may enter the first gas exhaust conduit internal channel via the first set of holes 804. The first set of holes 804 may comprise at least ten, at least fifteen, or at least twenty holes. The first set of holes 804 extend in a direction parallel to the main axis F of the first gas exhaust conduit 802. The holes in the first set of holes 804 each have a hole diameter d₁. The hole diameter d₁ may increase towards the top end 806 of the first gas exhaust conduit 802. The hole diameter d₁ may be different for each of the holes in the first set of holes 804, that is, the hole diameter d₁ may increase by an increment from one hole to an adjacent hole. The hole diameter d₁ may increase every two holes or every three holes or every four holes. The distance between the centres of two adjacent holes may be constant along the axis of the first gas exhaust conduit 802 or may vary. By having larger diameter holes towards the top end 806 of the first gas exhaust conduit 802 and smaller diameter holes towards the bottom end 807 of the first gas exhaust conduit 802, allowing relatively more gas to enter the first gas exhaust conduit 802 in the region of the first gas exhaust conduit 802 containing larger holes and relatively less in the region of the first gas exhaust conduit 802 containing smaller holes, the first gas exhaust conduit 802 is configured to preferentially extract gas from an upper region of the process chamber 102 as compared with a lower region of the process chamber 102.

The second gas exhaust conduit 803 comprises a second set of holes 808 in the second gas exhaust conduit wall 809, such that a gas may enter the second gas exhaust conduit internal channel via the second set of holes 808. The second set of holes 808 extend in a direction parallel to the main axis of the second gas exhaust conduit 803. The second set of holes 808 may comprise at least ten, at least fifteen, or at least twenty holes. The holes in the second set of holes 808 each have a hole diameter d₂. The hole diameter d₂ may decrease towards the top end 810 of the second gas exhaust conduit 803. The hole diameter d₂ may be different for each of the holes in the second set of holes 808, that is, the hole diameter d₂ may increase by an increment from one hole to an adjacent hole. The hole diameter d₂ may increase every two holes or every three holes. The distance between the centres of two adjacent holes may be constant along the axis of the second gas exhaust conduit 803 or may vary. By having larger diameter holes towards the bottom end 811 of the second gas exhaust conduit 803 and smaller diameter holes towards the top end 810 of the second gas exhaust conduit 803, allowing relatively more gas to enter the second gas exhaust conduit 803 in the region of the second gas exhaust conduit 803 containing larger holes and relatively less in the region of the second gas exhaust conduit 803 containing smaller holes, the second gas exhaust conduit 803 is configured to preferentially extract gas from a lower region of the process chamber 102 as compared with an upper region of the process chamber 102.

By providing the first gas exhaust conduit 802 and the second gas exhaust conduit 803 with oppositely varying hole diameters in the semiconductor processing apparatus 101 according to embodiments of the present invention, a gas extraction profile from the process chamber 102 can be made more uniform.

The hole diameters of a gas exhaust conduit may be chosen so as to achieve a particular ratio of extraction from a top half of the set of holes relative to the bottom half of the set of holes in that gas exhaust conduit.

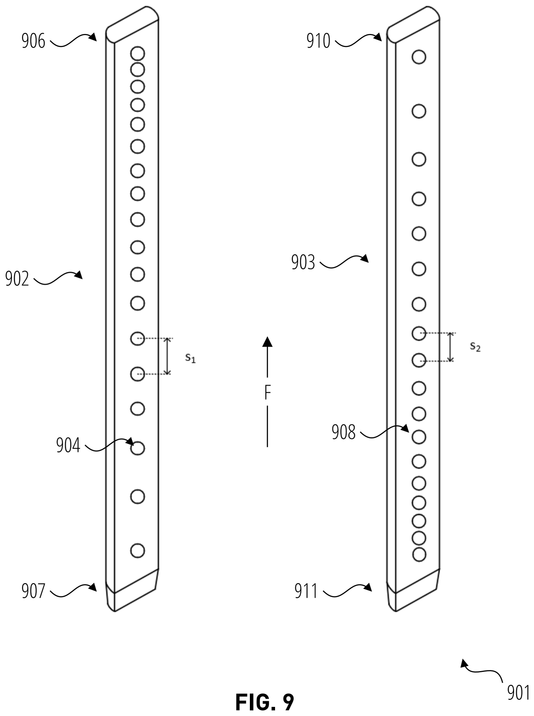

Referring to FIG. 9, in another embodiment of a gas exhaust conduit pair 901, the first gas exhaust conduit 902 may have a first hole spacing s₁ along the main axis F between adjacent holes in the plurality of holes and a second gas exhaust conduit 903 may have a second hole spacing s₂ along the main axis F between adjacent holes in the plurality of holes. The first hole spacing s₁ may be different to the second hole spacing s₂. The diameter of the holes in the first gas exhaust conduit 902 may be constant and the diameter of the holes in the second gas exhaust conduit 903 may be constant.

For example, in some embodiments, the first hole spacing s₁ may decrease towards the top end 904 of the first gas exhaust conduit 902 and the second hole spacing s₂ may increase towards the top end 906 of the second gas exhaust conduit 903.

By having a relatively smaller hole spacing towards the top end 904 of the first gas exhaust conduit 902 and a relatively larger hole spacing towards the bottom end 907 of the first gas exhaust conduit 902, allowing relatively more gas to enter the first gas exhaust conduit 902 in the region of the first gas exhaust conduit 902 having a smaller hole spacing and relatively less in the region of the first gas exhaust conduit 902 having a larger hole spacing, the first gas exhaust conduit 902 is configured to preferentially extract gas from an upper region of the process chamber 102 as compared with a lower region of the process chamber 102.

By having a relatively smaller hole spacing towards the bottom end 911 of the second gas exhaust conduit 903 and a relatively larger hole spacing towards the top end 910 of the second gas exhaust conduit 903, allowing relatively more gas to enter the second gas exhaust conduit 903 in the region of the second gas exhaust conduit 903 having a smaller hole spacing and relatively less in the region of the second gas exhaust conduit 903 having a larger hole spacing, the second gas exhaust conduit 903 is configured to preferentially extract gas from a lower region of the process chamber 102 as compared with an upper region of the process chamber 102.

By providing the first gas exhaust conduit 902 and the second gas exhaust conduit 903 with oppositely varying hole spacing in the semiconductor processing apparatus 101 according to embodiments of the present invention, a gas extraction profile from the process chamber 102 can be made more uniform.

Referring to FIG. 10, in another embodiment of a gas exhaust conduit pair 1001 which may be comprised in a semiconductor processing apparatus 101 according to embodiments of the present invention, the first gas exhaust conduit 1002 extends from a bottom, open end 1007 at which the first gas exhaust conduit 1002 is connectable to a gas outlet 110, to a top, open end 1004, along a main axis F. The second gas exhaust conduit 1003 extends from a bottom, open end 1011 at which the second gas exhaust conduit 1003 is connectable to a gas outlet 110, to a top, closed end 1010, along a main axis F. Each gas exhaust conduit 1002, 1003 has a respective gas exhaust conduit internal channel (FIG. 11) defined by a gas exhaust conduit wall.

The second gas exhaust conduit 1003 comprises a second set of holes 1008 in the second gas exhaust conduit wall 1009, such that a gas may enter the second gas exhaust conduit internal channel via the second set of holes 1008. The second set of holes 1008 extend in a direction parallel to the main axis of the second gas exhaust conduit 1003. The second set of holes 1008 may comprise at least ten, at least fifteen, or at least twenty holes. The holes in the second set of holes 1008 each have a hole diameter d₂. The hole diameter d₂ may decrease towards the top end 1010 of the second gas exhaust conduit 1003. The hole diameter d₂ may be different for each of the holes in the second set of holes 1008, that is, the hole diameter d₂ may increase by an increment from one hole to an adjacent hole. The hole diameter d₂ may increase every two holes or every three holes. The distance between the centres of two adjacent holes may be constant along the axis of the second gas exhaust conduit 1003 or may vary. By having larger diameter holes towards the bottom end 1011 of the second gas exhaust conduit 1003 and smaller diameter holes towards the top end 1010 of the second gas exhaust conduit 1003, allowing relatively more gas to enter the second gas exhaust conduit 1003 in the region of the second gas exhaust conduit 1003 containing larger holes and relatively less in the region of the second gas exhaust conduit 1003 containing smaller holes, the second gas exhaust conduit 1003 is configured to preferentially extract gas from a lower region of the process chamber 102 as compared with an upper region of the process chamber 102.

By providing the first gas exhaust conduit 1002 and the second gas exhaust conduit 1003 in the semiconductor processing apparatus 101 according to embodiments of the present invention, a gas extraction profile from the process chamber 102 can be made more uniform, as the second gas exhaust conduit 1003 may preferentially extract gas from a lower part of the process chamber 102 and the first gas exhaust conduit 1002 may preferentially extract gas from an upper part of the process chamber 102.

The hole diameters of a gas exhaust conduit may be chosen so as to achieve a particular ratio of extraction from a top half of the set of holes relative to the bottom half of the set of holes in that gas exhaust conduit.

Referring to FIG. 11, the first gas exhaust conduit internal channel 1120 and the second gas exhaust conduit internal channel may each have a cross-sectional area A1 in a plane perpendicular to the main axis F which is at least 1000mm². The cross-sectional area may be at least 2000mm². The cross-sectional area may be chosen depending on a desired pressure to be achieved in the process chamber. The cross-section may have a rounded rectangular shape. The cross-section may have an oval shape. The external shape of the gas exhaust conduit wall may be the same or different to the shape of the gas exhaust conduit internal channel. Referring again to FIG. 4 to FIG. 7, each of the first gas exhaust conduit 802, 902, 1002 and the second gas exhaust conduit 803, 903, 1003 may be positioned in the process chamber 102 such that a longer side of the rectangular shape is substantially tangential to a circumference of the process chamber 102. The holes 804, 808 may be provided in a longer side of the rectangular shape or a shorter side of the rectangular shape.

The holes 804, 808 may be arranged such that, when a gas exhaust conduit 802, 902, 803, 903, 1003 is provided in a process chamber 102 of a semiconductor processing apparatus 101 according to embodiments of the present invention, gas is removed from the process chamber 102 along a radial direction from a central axis of the process chamber 102. The holes 804, 808 may be arranged such that gas is removed from the process chamber 102 along a circumferential direction of the process chamber 102.

Various positionings of the holes in the first gas exhaust conduit 802, 902, 1002 and the second gas exhaust conduit 803, 903, 1003 relative to the substrate carrier 113 in the process chamber 102 are encompassed within the present invention.

The plurality of holes in the first gas exhaust conduit 802, 902 comprises a topmost hole being that hole in the first set of holes 804 which is closer to the top end 806 of the first gas exhaust conduit 802 than any of the other holes in the first set of holes 804. The first gas exhaust conduit 802, 902 may be positioned in the process chamber 102 such that the topmost hole of the first gas exhaust conduit 802 is higher than a topmost substrate receiving position of the substrate carrier 113. The topmost substrate receiving position of the substrate carrier 113 is that substrate receiving position which is closest to the top end 103 of the process chamber 102 when the substrate carrier 113 is positioned in the process chamber 102.

In some embodiments, the first gas exhaust conduit 802, 902 may be positioned in the process chamber 102 such that the topmost hole of the first gas exhaust conduit 802, 902 is lower than the topmost substrate receiving position of the substrate carrier 113. In some embodiments, the first gas exhaust conduit 802 may be positioned in the process chamber 102 such that the topmost hole of the first gas exhaust conduit 802 is substantially level with the topmost substrate receiving position of the substrate carrier 113.

The second set of holes 808 in the second gas exhaust conduit 803 comprises a lowest hole being that hole in the plurality of holes which is closer to the bottom end 811 of the second gas exhaust conduit 803 than any of the other holes in the second set of holes 808. The second gas exhaust conduit 803 may be positioned in the process chamber 102 such that the lowest hole of the second gas exhaust conduit 803 is lower than a lowest substrate receiving position of the substrate carrier 113. The second gas exhaust conduit 803 may be positioned in the process chamber 102 such that the lowest hole of the second gas exhaust conduit 803 is higher than a lowest substrate receiving position of the substrate carrier 113. The second gas exhaust conduit 803 may be positioned in the process chamber 102 such that the lowest hole of the second gas exhaust conduit 803 is substantially level with a lowest substrate receiving position of the substrate carrier 113.

In some embodiments, the top end 810 of the second gas exhaust conduit 803 is positioned lower than the top end 806 of the first gas exhaust conduit 802.

In some embodiments, each gas exhaust conduit may be connected to a flow controllable gas line which allows the gas flow through each gas exhaust conduit to be individually controllable. The level of control may be binary i.e. flow versus no flow, or may be variable in terms of the amount of flow permitted.

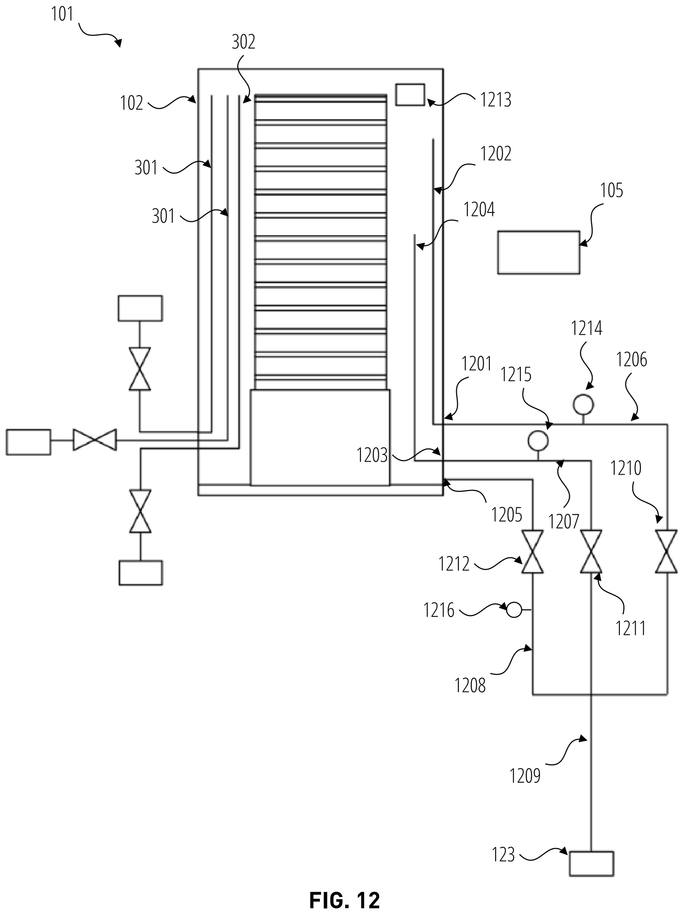

Referring to FIG. 12, a schematic view of a semiconductor processing apparatus 101 according to embodiments of the present invention comprising three gas inlets and three gas outlets is shown. For example, the gas divider ring 401 of Configuration D, FIG. 5 may be comprised in the semiconductor processing apparatus 101 of FIG. 12. The three gas outlets comprise a first gas outlet 1201 connected to a first gas exhaust conduit 1202, a second gas outlet 1203 connected to a second gas exhaust conduit 1204, and an (optional) third gas outlet 1205 not being connected to a gas exhaust conduit. The first gas outlet 1201 is in fluid communication with a first exhaust gas line 1206. The second gas outlet 1203 is in fluid communication with a second exhaust gas line 1207. The (optional) third gas outlet 1205 is in fluid communication with a third exhaust gas line 1208. The first exhaust gas line 1206, second exhaust gas line 1207, and third exhaust gas line 1208 are each connected to a foreline 1209 which is in fluid communication with a vacuum pump 123. It is noted that although entry/exit points to the process chamber 102 for the gas lines are shown at different vertical positions, this is not intended to be restrictive and such entry/exit points may be at different horizonal positions, for example distributed around a circumference of process chamber 102. The gas entry/exit points may be at varying vertical and horizontal positions.

The first exhaust gas line 1206 may comprise a first gas flow control valve 1210 upstream of the foreline 1209. The second exhaust gas line 1207 may comprise a second gas flow control valve 1211 upstream of the foreline 1209. The third exhaust gas line 1208, if included, may comprises a third gas flow control valve 1212 upstream of the foreline 1209.

By controlling gas flow through the first gas exhaust conduit 1202 and the second gas exhaust conduit 1204 using one or more of the gas flow control valves 1210, 1211, 1212, an amount of gas exhausted via the first gas exhaust conduit 1202 relative to the second gas exhaust conduit 1204 can be controlled. In combination with the hole configuration of the first gas exhaust conduit 1202 and the second gas exhaust conduit 1204 (e.g., varying diameter with height and/or varying hole spacing with height), this allows control over the profile of gas extraction from the process chamber 102 via the first gas exhaust conduit 1202 and second gas exhaust conduit 1204. This profile can be chosen to be similar or matching to the gas injection pattern of the multi-hole injector(s) 301, providing more uniform cross-flow of gas across the substrate carrier 113 and less variation in cross-flow rate across the height of the substrate carrier 113, as compared with a reference semiconductor processing apparatus not comprising gas exhaust conduits according to embodiments of the present invention.

For example, in some embodiments, the semiconductor processing apparatus 101 comprises a controller 105 configured to control the first gas flow control valve 1210 and the second gas flow control valve 1211 such that, during provision of gas to the process chamber 102 via the multi-hole injectors 301, the first gas flow control valve 1210 controls the first exhaust gas line 1206 to be open and the second gas flow control valve 1211 controls the second exhaust gas line 1207 to be closed for a first duration; and subsequently the first gas flow control valve 1210 controls the first exhaust gas line 1206 to be closed and the second gas flow control valve 1211 controls the second exhaust gas line 1207 to be open for a second duration. By controlling the duration for which gas flow is allowed through each gas exhaust conduit, an amount of gas exhausted via the first gas exhaust conduit 1202 relative to the second gas exhaust conduit 1204 can be controlled. The first duration and the second duration may be chosen so as to match the profile of gas extraction over the height of the process chamber 102 with the gas injection profile of the multi-hole injectors 301. In such embodiments a pressure sensor may not be required in the exhaust gas lines 1206, 1207 or in the foreline 1209.

In some embodiments, the first gas flow control valve 1210 is a pressure control valve configured to control an amount of gas flowing through the first exhaust gas line 1206 in a variable manner from a minimum to a maximum flow restriction and the second gas flow control valve 1211 is a pressure control valve configured to control an amount of gas flowing through the second exhaust gas line 1207 in a variable manner from a minimum to a maximum flow restriction. The first exhaust gas line 1206 may comprise at least one first exhaust line pressure sensor 1214, also referred to as pressure transducer, and the second exhaust gas line 1207 may comprise at least one second exhaust line pressure sensor 1215, also referred to as pressure transducer. The semiconductor processing apparatus 101 may comprise a controller 105 configured to control the pressure control valves in the first exhaust gas line 1206 and the second exhaust gas line 1207 so as to provide a desired flow rate ratio through the first exhaust gas line 1206 and second exhaust gas line 1207. The controller 105 may be configured to control the flow rate ratio so as to match a total gas exhaust profile provided by the first gas exhaust conduit 1202 and second gas exhaust conduit 1204 with a gas injection profile provided by the at least one multi-hole injector 301.

In some embodiments, the first exhaust gas line 1206 comprises a first gas flow control valve 1210 which is a first exhaust line pressure control valve and the second exhaust gas line 1207 comprises a second gas flow control valve 1211 which is a second exhaust line pressure control valve and neither gas exhaust line comprises a pressure sensor. A conductance characterisation of each of the two exhaust gas lines 1206, 1207 may be carried out to determine a relation between conductance of an exhaust gas line 1206, 1207 and a valve opening amount of the pressure control valve comprised in the respective exhaust gas line 1206, 1207, for varying gas flow rates through the exhaust gas line 1206, 1207. Given a process chamber pressure setpoint and the flow fraction through each exhaust gas line 1206, 1207, the target conductance of each of the two exhaust gas lines can be determined. The exhaust conductance characterization determines, from the target conductance, the position setpoint for each of the pressure control valves. This relation may be stored in a memory comprised in the controller 105 and accessed by a processor comprised in the controller 105 so as to provide a position setpoint to each of the pressure control valves which corresponds to a desired conductance for each exhaust gas line.

In some embodiments, the first exhaust gas line 1206 comprises a first gas flow control valve 1210 which is a first exhaust line pressure control valve, and a first exhaust line pressure sensor 1214, and the second exhaust gas line 1207 comprises a second gas flow control valve 1211 which is a second exhaust line pressure control valve, and a second exhaust line pressure sensor 1215. The foreline 1209 may comprise a foreline pressure sensor. A conductance characterisation of each of the two exhaust gas lines 1206, 1207 may be carried out to determine a relation between conductance of an exhaust gas line 1206, 1207 and a valve opening amount of the pressure control valve comprised in the respective exhaust gas line 1206, 1207, for varying gas flow rates through the exhaust gas line 1206, 1207. Given a process chamber pressure setpoint and the flow fraction through each exhaust gas line 1206, 1207, the target conductance of each of the two exhaust gas lines can be determined. The exhaust conductance characterization determines, from the target conductance, the position setpoint for each of the pressure control valves. This relation may be stored in a memory comprised in the controller 105 and accessed by a processor comprised in the controller 105 so as to provide a position setpoint to each of the pressure control valves which corresponds to a desired conductance for each exhaust gas line. The controller 105 may be configured to measure gas flow through the respective exhaust gas lines 1206, 1207 by calculating the difference between the pressure measured by the exhaust line pressure sensors 1214, 1215 and the foreline pressure sensor and thereby to correct the position setpoint to each of the control valve by a PID control loop to match the desired gas flow through each of the exhaust gas lines 1206, 1207.

In some embodiments, the first exhaust gas line 1206 comprises a first gas flow control valve 1210 which is a first exhaust line pressure control valve, and a first exhaust line pressure sensor 1214, and the second exhaust gas line 1207 comprises a second exhaust line pressure sensor 1215 and no pressure control valve. The second exhaust gas line 1207 has a fixed flow restriction resulting in a conductance of the second exhaust gas line 1207 which is similar to a conductance of the first exhaust line pressure control valve at a low position. The foreline 1209 comprises a foreline pressure sensor and a foreline pressure control valve. The controller 105 may be configured to measure gas flow through the respective exhaust gas lines 1206, 1207 by calculating the difference between the pressure measured by the exhaust line pressure sensors 1214, 1215 and the foreline pressure sensor. The controller 105 may be configured to control a pressure in the process chamber 102 by controlling the foreline pressure control valve. The controller 105 may be configured to receive pressure measurements from a process chamber pressure sensor 1213 and to control a position of the foreline pressure control valve based on such received process chamber pressure measurements. The controller may be configured to control a flow ratio between the first exhaust gas line and the second exhaust gas line by controlling the first exhaust line pressure control valve.

In some embodiments, the first exhaust gas line 1206 comprises a first gas flow control valve 1210 which is a first exhaust line pressure control valve, and a first exhaust line pressure sensor 1214, and the second exhaust gas line 1207 comprises a second gas flow control valve 1211 which is a second exhaust line pressure control valve, and a second exhaust line pressure sensor 1215. The controller 105 may be configured to indirectly measure the flow through the first exhaust gas line 1206 and the second exhaust gas line 1207 by determining the pressure drop across the respective gas exhaust conduit, by calculating the difference between the process chamber pressure (for example as provided by a process chamber pressure sensor), and the pressure in the respective exhaust gas line 1206, 1207.

One of the first exhaust line pressure sensor 1214 and the second exhaust line pressure sensor 1215 may be used to control a pressure in the process chamber and the other of the first exhaust line pressure sensor 1214 and the second exhaust line pressure sensor 1215 may be used to control the gas flow through the respective exhaust gas line by providing a position setpoint value for each of the pressure control valves 1210, 1211 to the controller 105.

In some embodiments, the first exhaust gas line 1206 comprises a first gas flow control valve 1210 which is a first exhaust line pressure control valve, and a first exhaust line pressure sensor 1214 which is a differential pressure sensor configured to directly measure a difference in pressure between the first exhaust gas line 1206 and the process chamber 102; and the second exhaust gas line 1207 comprises a second gas flow control valve 1211 which is a second exhaust line pressure control valve, and a second exhaust line pressure sensor 1215 which is a differential pressure sensor configured to directly measure a difference in pressure between the second exhaust gas line 1207 and the process chamber 102. The controller 105 may be configured to measure the flow rate ratio between flow through the first exhaust gas line 1206 and flow through the second exhaust gas line 1207 by determining the ratio between the pressure difference measurement provided by the first exhaust line pressure sensor 1214 (being a differential pressure sensor) and the pressure difference measurement provided by the second exhaust line pressure sensor 1215 (also being a differential pressure sensor).

Since the flow rate through an exhaust gas line is directly proportional to the pressure drop between the process chamber and that exhaust gas line, the flow rate ratio between gas flow in the first exhaust gas line 1206 and the second exhaust gas line 1207 can be found by taking the ratio of the differential pressure measured by the first exhaust line pressure sensor 1214 and that measured by the second exhaust line pressure sensor 1215. By taking the ratio of the two measurements, the constant of proportionality between flow rate and pressure drop is eliminated. This proportionality constant, which is substantially the same for each exhaust gas line, depends on characteristics of the gas which may be difficult to measure, making it challenging to directly determine the flow rate in one of the exhaust gas lines using only the differential pressure measurement in that gas line.

By using the ratio of two differential pressures, the requirement to calibrate the pressure measurements to account for characteristics of the gas flowing through the exhaust gas lines 1206, 1207 is removed. This may be particularly advantageous when measurements are taken throughout a process in which such characteristics may change unpredictably, such as the temperature of the gas, and the composition of the gas. For example, a gas exhausted from the process chamber 102 at the start of a deposition step may comprise a lesser quantity of reaction byproducts than a gas exhausted from the process chamber 102 towards the end of a deposition step, and this change in composition may be unpredictable and difficult to measure.

One of the first gas flow control valve 1210 and the second gas flow control valve 1211 may be used to control a pressure in the process chamber 102 and the other of the first gas flow control valve 1210 and the second gas flow control valve 1211 may be used to control the ratio of flow rate between the first exhaust gas line 1206 and the second exhaust gas line 1207.

In some embodiments, the first exhaust gas line 1206 comprises a first gas flow control valve 1210 which is a first exhaust line pressure control valve, and a first exhaust line pressure sensor 1214, and the second exhaust gas line 1207 comprises a second gas flow control valve 1211 which is a second exhaust line pressure control valve, and a second exhaust line pressure sensor 1215, and the third exhaust gas line 1208 comprises a third gas flow control valve 1212 which is a third exhaust line pressure control valve, and a third exhaust line pressure sensor 1216. The controller 105 may be configured to indirectly measure the flow through the first exhaust gas line 1206, the second exhaust gas line 1207, and the third exhaust gas line 1208 by calculating the difference between the process chamber pressure (for example as provided by a process chamber pressure sensor), and the pressure in the respective exhaust gas line 1206, 1207, 1208. The controller 105 may be configured to calculate a pressure setpoint for each pressure control valve 1210, 1211, 1212 based on a target pressure for the process chamber 102, target flows through each exhaust gas line, and a characterization of the exhaust gas lines. The controller 105 may be configured to, when the pressure setpoint is reached, maintain the pressure at the setpoint by a PID control loop that controls the process chamber pressure and flow distribution through the exhaust gas lines.

In some embodiments, a precursor gas and a reactant gas may be alternately provided in a cyclical manner through respective multi-hole injectors 301, for example in an atomic layer deposition process. Gas removal from the process chamber 102 may alternate between the first gas exhaust conduit 1202 and the second gas exhaust conduit 1204 for successive precursor provision steps. For example, in some embodiments, the first gas flow control valve 1210 may be set to be open and the second gas flow control valve 1211 may be set to be closed during a first precursor gas provision step, and the first gas flow control valve 1210 may be set to be closed and the second gas flow control valve 1211 may be set to be open during a second precursor gas provision step following the first precursor gas provision step. In some embodiments, the first gas flow control valve 1210 may be set to be open and the second gas flow control valve 1211 may be set to be closed during a first reactant gas provision step, and the first gas flow control valve 1210 may be set to be closed and the second gas flow control valve 1211 may be set to be open during a second reactant gas provision step following the first precursor gas provision step. In some embodiments, the first gas flow control valve 1210 may be set to be open and the second gas flow control valve 1211 may be set to be closed during a first precursor gas provision step and a first reactant gas provision step, and the first gas flow control valve 1210 may be set to be closed and the second gas flow control valve 1211 may be set to be open during a second precursor gas provision step and a second reactant gas provision step following the first precursor gas provision step and the first reactant gas provision step. It will be understood that various control schemes for the gas flow control valves are possible within the scope of the present invention in addition to those explicitly described herein.

In some embodiments, the flow ratio between the first gas exhaust conduit 1202 and the second gas exhaust conduit 1204 may alternate or vary for successive precursor provision steps. For example, in some embodiments, a first gas flow rate may be allowed through the first gas exhaust conduit 1202 during a first precursor gas provision step, and a second gas flow rate different to the first gas flow rate may be allowed through the first gas exhaust conduit 1202 during a second precursor gas provision step. A third gas flow rate may be allowed through the second gas exhaust conduit 1204 during the first precursor gas provision step, and a fourth gas flow rate different to the third gas flow rate may be allowed through the second gas exhaust conduit 1204 during the second precursor gas provision step. The flow rates may be controlled as described hereinbefore using various combinations of gas flow control valve(s) and pressure sensor(s). In some embodiments, a first gas flow rate may be allowed through the first gas exhaust conduit 1202 during a first reactant gas provision step, and a second gas flow rate different to the first gas flow rate may be allowed through the first gas exhaust conduit 1202 during a second reactant gas provision step. A third gas flow rate may be allowed through the second gas exhaust conduit 1204 during the first reactant gas provision step, and a fourth gas flow rate different to the third gas flow rate may be allowed through the second gas exhaust conduit 1204 during the second reactant gas provision step. The flow rates may be controlled as described hereinbefore using various combinations of gas flow control valve(s) and pressure sensor(s).

In some embodiments, a first gas flow rate may be allowed through the first gas exhaust conduit 1202 during a first precursor gas provision step and a first reactant gas provision step, and a second gas flow rate different to the first gas flow rate may be allowed through the first gas exhaust conduit 1202 during a subsequent second precursor gas provision step and second reactant gas provision step. In some embodiments, a third gas flow rate may be allowed through the second gas exhaust conduit 1104 during the first precursor gas provision step and the first reactant gas provision step, and a fourth gas flow rate different to the third gas flow rate may be allowed through the second gas exhaust conduit 1104 during the second precursor gas provision step and second reactant gas provision step.

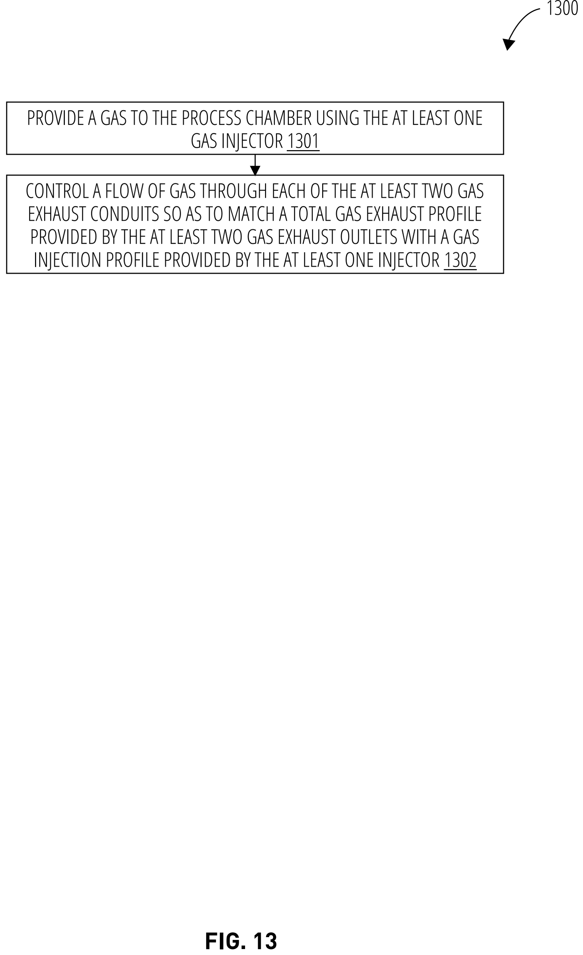

Referring to FIG. 13, a method of controlling gas flow through a semiconductor processing apparatus according to embodiments of the present invention comprises the steps of providing a gas to the process chamber using at least one multi-hole gas injector, step 1301 ; and controlling a flow of gas through each of the at least two gas exhaust conduits so as to match a total gas exhaust profile provided by the at least two gas exhaust outlets with a gas injection profile provided by the at least one injector, step 1302. The semiconductor processing apparatus comprises a process chamber configured to receive a plurality of substrates supported by a substrate carrier; at least one multi-hole gas injector for providing a gas to the process chamber; at least two gas exhaust outlets for removing a gas from the process chamber; at least two gas exhaust conduits, each connected to a respective gas exhaust outlet; a vacuum pump in fluid communication with the gas exhaust outlets; and means for controlling a flow of gas through each of the at least two gas exhaust conduits. The means for controlling gas flow may comprise a first valve for controlling gas flow from a first gas exhaust conduit of the at least two gas exhaust conduits to the vacuum pump and a second valve for controlling gas from a second gas exhaust conduit of the at least two gas exhaust conduits to the vacuum pump.

The method may comprise controlling the first and second valves so as to provide a different gas flow rate from the first gas exhaust conduit as compared with a simultaneous gas flow rate from the second gas exhaust conduit.

The method may comprise controlling the first and second valves so as to alternate in time the gas flow from the first gas exhaust conduit with the gas from the second gas exhaust conduit.

The gas flow control step 1302 may take place while contacting a substrate supported in the substrate carrier with a precursor during an atomic layer deposition process. The gas flow control step 1302 may take place while contacting a substrate supported in the substrate carrier with a precursor during an epitaxial deposition process.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

## Claims

1. A semiconductor processing apparatus comprising:
a process chamber configured to receive a plurality of substrates supported by a substrate boat;
at least one gas injector for providing a gas to the process chamber;
at least two gas exhaust outlets for removing a gas from the process chamber;
at least two gas exhaust conduits, each connected to a respective gas exhaust outlet;
wherein each of the gas exhaust conduits extends in a vertical direction inside the process chamber over at least part of the substrate boat; and
wherein at least one of the gas exhaust conduits comprises a plurality of holes spaced apart in the vertical direction.

2. The semiconductor processing apparatus of claim 1, wherein the at least two gas exhaust conduits comprises a top-extracting gas exhaust conduit having an inlet at a top end and an outlet at a bottom end, and a second gas exhaust conduit comprising a plurality of holes spaced apart in the vertical direction.

3. The semiconductor processing apparatus of claim 1, wherein the at least two gas exhaust conduits comprises a first gas exhaust conduit having a first hole diameter of the plurality of holes comprised in the first gas exhaust conduit, and a second gas exhaust conduit having a second diameter of a plurality of holes comprised in the second gas exhaust conduit, wherein the first hole diameter is different to the second hole diameter.

4. The semiconductor processing apparatus of claim 3, wherein the first hole diameter increases towards an end of the first gas exhaust conduit which is opposite to an end of the first gas exhaust conduit at which the first gas exhaust conduit is connected to the respective gas exhaust outlet.

5. The semiconductor processing apparatus of claim 4, wherein the second hole diameter decreases towards an end of the second gas exhaust conduit which is opposite to an end of the second gas exhaust conduit at which the second gas exhaust conduit is connected to the respective gas exhaust outlet.

6. The semiconductor processing apparatus of claim 1, wherein the at least two gas exhaust conduits comprises a first gas exhaust conduit having a first hole spacing between adjacent holes in the plurality of holes and a second gas exhaust conduit having a second hole spacing between adjacent holes in the plurality of holes, wherein the first hole spacing is different to the second hole spacing.

7. The semiconductor processing apparatus of claim 6, wherein the first hole spacing decreases towards an end of the first gas exhaust conduit which is opposite to an end of the first gas exhaust conduit at which the first gas exhaust conduit is connected to the respective gas exhaust outlet.

8. The semiconductor processing apparatus of claim 6 or 7, wherein the second hole spacing increases towards an end of the second gas exhaust conduit which is opposite to an end of the second gas exhaust conduit at which the second gas exhaust conduit is connected to the respective gas exhaust outlet.

9. The semiconductor processing apparatus of any one of claims 1 to 8, wherein the first gas exhaust conduit or top-extracting gas exhaust conduit is configured to preferentially extract gas from an upper region of the process chamber and the second gas exhaust conduit is configured to preferentially extract gas from a lower region of the process chamber.

10. The semiconductor processing apparatus of any one of claims 1 to 9, wherein the at least one gas injector is located diametrically opposite to a midpoint of the at least two gas exhaust conduits in a direction along a circumference of the process chamber.

11. The semiconductor processing apparatus of any one of claims 1 to 10, wherein each of the at least two gas exhaust conduits has an internal gas conduction channel extending from a bottom end of the respective gas exhaust conduit to a top end opposite the bottom end, wherein the internal gas conduction channel has a cross-sectional area in a horizontal plane of at least 2000mm².

12. The semiconductor processing apparatus of claim 11, wherein the internal gas conduction channel has a rounded rectangular shape in the horizonal plane.

13. The semiconductor processing apparatus of claim 12, wherein each of the at least two gas exhaust conduits is positioned in the process chamber such that a longer side of the rectangular shape is substantially tangential to a circumference of the process chamber.

14. The semiconductor processing apparatus of any one of claims 1 to 12, wherein the second gas exhaust conduit has a top end which is lower than a top end of the first gas exhaust conduit.

15. The semiconductor processing apparatus of any one of claims 1 to 14, comprising a base pressure evacuation outlet for removing gas from the process chamber, wherein the base pressure evacuation outlet is not connected to any of the at least two gas exhaust conduits.

16. The semiconductor processing apparatus of any one of claims 1 to 15, comprising:
a vacuum pump in fluid communication with the gas exhaust outlets;
a first gas line providing a fluid connection between the first gas exhaust outlet and the vacuum pump; and
a second gas line providing a fluid connection between the second gas exhaust outlet and the vacuum pump;
wherein the first gas line comprises a first gas control valve and the second gas line comprises a second gas control valve.

17. The semiconductor processing apparatus of claim 16, wherein the first and second gas control valves are pressure control valves configured to control a flow rate of a gas through the respective gas line, wherein the first gas line comprises at least one first gas line pressure sensor and the second gas line comprises at least one second gas line pressure sensor.

18. The semiconductor processing apparatus of claim 17, wherein at least one of the pressure sensors is a differential pressure sensor configured to measure a pressure difference between the respective gas line and the process chamber.

19. The semiconductor processing apparatus of claim 17, further comprising a controller configured to control the pressure control valves so as to provide a desired flow rate ratio of gas through the first and the second gas lines.

20. A method of controlling gas flow through a semiconductor processing apparatus, the semiconductor processing apparatus comprising:
a process chamber configured to receive a plurality of substrates supported by a substrate boat;
at least one gas injector for providing a gas to the process chamber;
at least two gas exhaust outlets for removing a gas from the process chamber;
at least two gas exhaust conduits, each connected to a respective gas exhaust outlet;
a vacuum pump in fluid communication with the gas exhaust outlets; and
means for controlling a flow of gas through each of the at least two gas exhaust conduits;
the method comprising the steps of:
providing a gas to the process chamber using the at least one gas injector; and
controlling a flow of gas through each of the at least two gas exhaust conduits so as to match a total gas exhaust profile provided by the at least two gas exhaust outlets with a gas injection profile provided by the at least one injector.
